(19) Europäisches Patentamt
European Patent Office
Office européen des brevets

(11) **EP 1 916 721 B1**

## (12) EUROPÄISCHE PATENTSCHRIFT

(45) Veröffentlichungstag und Bekanntmachung des Hinweises auf die Patenterteilung:
**09.07.2014 Patentblatt 2014/28**

(51) Int Cl.:
*H01L 41/053* (2006.01)  *H01L 41/083* (2006.01)
*F02M 51/06* (2006.01)  *H02N 2/02* (2006.01)

(21) Anmeldenummer: **07115909.9**

(22) Anmeldetag: **07.09.2007**

(54) **Piezoelektrischer Aktor**

Piezo-electric actuator

Actionneur piézoélectrique

(84) Benannte Vertragsstaaten:
**DE ES FR**

(30) Priorität: **25.10.2006 DE 102006050174**

(43) Veröffentlichungstag der Anmeldung:
**30.04.2008 Patentblatt 2008/18**

(73) Patentinhaber: **ROBERT BOSCH GMBH**
**70442 Stuttgart (DE)**

(72) Erfinder:
• **Schaich, Udo**
**70378, Stuttgart (DE)**
• **Kiontke, Martin**
**70825, Korntal-Muenchingen (DE)**

(56) Entgegenhaltungen:
WO-A1-2005/053046  WO-A1-2006/089818
DE-A1-102004 002 133  US-A- 4 160 184

EP 1 916 721 B1

**Beschreibung**

Stand der Technik

Die Erfindung betrifft einen piezoelektrischen Aktor für ein Brennstoffeinspritzventil und ein Brennstoffeinspritzventil mit solch einem piezoelektrischen Aktor. Speziell betrifft die Erfindung das Gebiet der Injektoren für Brennstoffeinspritzanlagen von luftverdichtenden, selbstzündenden Brennkraftmaschinen.

Aus der DE 100 25 998 A1 ist ein Piezoaktor mit einem Mehrschichtaufbau von Piezolagen und zwischen den Lagen angeordneten Innenelektroden, die mit einer elektrischen Spannung beaufschlagbar sind, bekannt. Ferner ist ein inaktiver Bereich an einem Ende des Mehrschichtaufbaus vorgesehen, wobei durch die Länge des inaktiven Bereichs die erforderliche Gesamteinbaulänge des Piezoaktors anpassbar ist. Ferner ist über einen Metall- oder Keramikblock eine mechanische und/oder thermische Anbindung an ein weiteres Bauteil und/oder eine elektrische Isolation durchführbar.

Der aus der DE 100 25 998 A1 bekannte Piezoaktor hat den Nachteil, dass durch den inaktiven Bereich des Piezoaktors eine parasitäre Kapazität ausgebildet ist. Auf Grund der hohen Frequenz, mit der speziell die an den inaktiven Bereich angrenzende Innenelektrode mit einer Spannung beaufschlagt wird, wird ein Störstrom erzeugt, der sich über das Antennensystem einkoppeln und den Empfang des Radius stören kann. Allgemein wirkt sich so ein Störstrom ungünstig auf die elektromagnetische Verträglichkeit aus.

DE 10 2004 002 133 A1 offenbart einen piezoelektrischen Aktor, der an seinen stirnseitigen Enden jeweils eine äußere Deckschicht, beispielsweise aus Glas, aufweist.

Offenbarung der Erfindung

Vorteilhafte Wirkungen

Der erfindungsgemäße piezoelektrische Aktor mit den Merkmalen des Anspruchs 1 und das erfindungsgemäße Brennstoffeinspritzventil mit den Merkmalen des Anspruchs 6 haben den Vorteil, dass die elektromagnetische Verträglichkeit verbessert ist. Insbesondere sind Störströme, die auf Grund von parasitären Kapazitäten des piezoelektrischen Aktors entstehen, verringert.

Durch die in den Unteransprüchen aufgeführten Maßnahmen sind vorteilhafte Weiterbildungen des im Anspruch 1 angegebenen piezoelektrischen Aktors und des im Anspruch 6 angegebenen Brennstoffeinspritzventils möglich.

Eine Glaskeramikplatte, die zwischen dem Übergangsstück und der passiven keramischen Schicht des Aktorkörpers vorgesehen ist, bewirkt, dass die parasitäre Kapazität zwischen der an die passive keramische Schicht angrenzende Elektrodenschicht und dem Übergangsstück verringert ist. In Abhängigkeit von der Ausgestaltung eines Brennstoffeinspritzventils kann, beispielsweise über metallische Kontaktstellen der Stahlbauteile, das Übergangsstück mit einem Ventilgehäuse des Brennstoffeinspritzventils verbunden sein. Über den Motorblock ist dann das Übergangsstück auch mit der Fahrzeugmasse verbunden. Über die Ladung und Entladung der parasitären Kapazität mit der beim Betrieb des Brennstoffeinspritzventils benötigten hohen Steuerfrequenz kommt es auf Grund der reduzierten parasitären Kapazität auch zu einer Reduzierung des entsprechenden Störstroms, so dass die elektromagnetische Verträglichkeit verbessert ist. Hierbei kann durch eine relativ niedrige Permittivität (dielektrische Permeabilität) eine wesentliche Reduzierung der parasitären Kapazität auch bei relativ geringer Dicke der Glaskeramikplatte erreicht werden. Somit kommt es zu keiner wesentlichen Änderung der Einbaulänge des piezoelektrischen Aktors. Insbesondere kann eine derartige Längenänderung auf der Seite eines als Aktorkopf ausgestalteten Übergangsstücks kompensiert werden. Die Glaskeramikplatte zwischen der passiven keramischen Schicht und dem Übergangsstück ist nicht notwendigerweise homogen ausgestaltet. Bei einer relativ homogenen Ausgestaltung ist die Permittivität zumindest näherungsweise gleich einer Dielektrizitätskonstante des jeweiligen Materials. Speziell ist dann die relative Permittivität gleich einer relativen Dielektrizitätskonstante des Materials.

In vorteilhafter Weise ist die Glaskeramikplatte klebstofffrei mit dem Übergangsstück verbunden. Insbesondere ist es vorteilhaft, dass die Glaskeramikplatte durch Sintern mit den keramischen Schichten verbunden ist. Dadurch ist eine feste Verbindung zwischen der Glaskeramikplatte und dem Aktorkörper geschaffen, so dass über die Lebensdauer des Aktors ein Verrutschen der Glaskeramikplatte verhindert ist. Speziell werden mechanische Spannungsspitzen, die durch ein Verrutschen der Glaskeramikplatte entstehen können, verhindert. Ferner kann die Glaskeramikplatte nach dem Sintern zusammen mit dem Aktorkörper nachbearbeitet werden. Eine genaue Positionierung, insbesondere Zentrierung, ist dann nicht erforderlich.

Erfindungsgemäß weist die Glaskeramikplatte eine Dicke auf, die aus einem Bereich von etwa 0,15 mm bis etwa 0,25 mm ist. Speziell weist die Glaskeramikplatte eine Dicke von etwa 0,2 mm auf. Mit einer relativen Permittivität der Glaskeramikplatte, die kleiner als 10, insbesondere kleiner als 6, ist, kann dann eine in Bezug auf die Kapazität der passiven keramischen Schicht relativ kleine Kapazität der Glaskeramikplatte geschaffen werden. Die entstehende Gesamtkapazität des parasitären Kondensators kann somit erheblich verringert werden, ohne dass die Gesamteinbaulänge des Aktors wesentlich vergrößert wird.

Vorteilhaft ist es, dass ein weiteres Übergangsstück vorgesehen ist und dass zwischen einer an einem weiteren Ende des Aktorkörpers vorgesehenen weiteren passiven keramischen Schicht des Aktorkörpers und dem weiteren Übergangsstück eine weitere Glaskeramikplatte vorgesehen ist. Die Ausgestaltung der Glaskeramikplatte und die Verbindung der Glaskeramikplatte mit dem Aktorkörper beziehungsweise mit dem Übergangsstück kann entsprechend weitergebildet werden. Eines der Übergangsstücke kann dann als Aktorfuß dienen und das andere Übergangsstück kann als Aktorkopf dienen. Eine mögliche Kompensation der durch zumindest eine Glaskeramikplatte entstehenden geringfügigen Verlängerung der Aktorlänge erfolgt vorzugsweise auf der Seite des Aktorkopfes, so dass die äußere Geometrie des gesamten piezoelektrischen Aktors unverändert und ein Einsatz in bestehende Brennstoffeinspritzventile möglich ist.

## Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt:

Fig. 1 ein Brennstoffeinspritzventil mit einem piezoelektrischen Aktor in einer schematischen Schnittdarstellung entsprechend einem ersten Ausführungsbeispiel der Erfindung;

Fig. 2 den in Fig. 1 mit II bezeichneten Ausschnitt eines erfindungsgemäßen piezoelektrischen Aktors eines Brennstoffeinspritzventils mit einem Ersatzschaltbild und

Fig. 3 den in Fig. 1 mit II bezeichneten Ausschnitt eines nicht erfindungsgemäßen piezoelektrischen Aktors eines Brennstoffeinspritzventils.

## Ausführungsformen der Erfindung

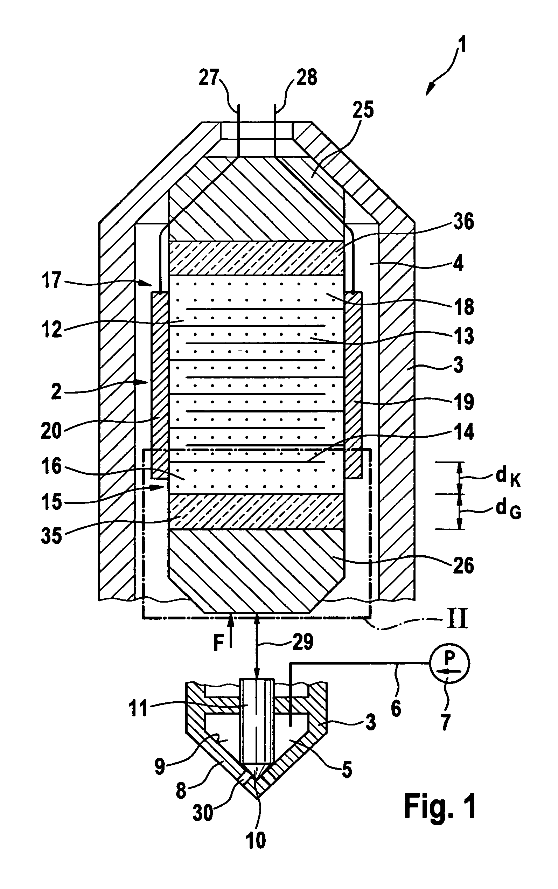

Fig. 1 zeigt ein Brennstoffeinspritzventil 1 mit einem piezoelektrischen Aktor 2 entsprechend einem ersten Ausführungsbeispiel der Erfindung. Das Brennstoffeinspritzventil 1 kann insbesondere als Injektor für Brennstoffeinspritzanlagen von luftverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Der erfindungsgemäße piezoelektrische Aktor 2 eignet sich besonders für solch ein Brennstoffeinspritzventil 1. Das erfindungsgemäße Brennstoffeinspritzventil 1 und der erfindungsgemäße piezoelektrische Aktor 2 eignen sich jedoch auch für andere Anwendungsfälle.

Das Brennstoffeinspritzventil 1 weist ein Ventilgehäuse 3 auf. Im Inneren des Ventilgehäuses 3 ist ein Aktorraum 4 ausgebildet, in dem der piezoelektrische Aktor 2 angeordnet ist. Ferner ist an einem düsenseitigen Ende des Ventilgehäuses 3 ein Brennstoffraum 5 ausgebildet, in den eine Brennstoffleitung 6 mündet. Eine Hochdruckpumpe 7 pumpt Brennstoff direkt oder über ein Common-Rail in den Brennstoffraum 5, so dass sich im Betrieb des Brennstoffeinspritzventils 1 im Brennstoffraum 5 unter hohem Druck stehender Brennstoff befindet.

An einem mit dem Ventilgehäuse 3 verbundenen Ventilsitzkörper 8 ist eine Ventilsitzfläche 9 ausgebildet, die mit einem Ventilschließkörper 10 zu einem Dichtsitz zusammenwirkt. Der Ventilschließkörper 10 ist mit einer Ventilnadel 11 verbunden, um den Ventilschließkörper 10 zu betätigen.

Der in dem Aktorraum 4 angeordnete Aktor 2 weist einen Aktorkörper 12 auf, der eine Vielzahl von keramischen Schichten 13 und eine Vielzahl von zwischen den keramischen Schichten angeordneten Elektrodenschichten 14 umfasst. Zur Vereinfachung der Darstellung sind in der Fig. 1 exemplarisch die keramische Schicht 13 und die Elektrodenschicht 14 bezeichnet. Ferner ist an einem Ende 15 des Aktorkörpers eine passive keramische Schicht 16 ausgebildet, an die die Elektrodenschicht 14 angrenzt. An einem weiteren Ende 17 des Aktorkörpers 12 ist eine weitere passive keramische Schicht 18 ausgebildet.

Der piezoelektrische Aktor 2 weist Außenelektroden 19, 20 auf, wobei ein Teil der Elektrodenschichten 14 mit der Außenelektrode 19 verbunden ist und der andere Teil der Elektrodenschichten 14 mit der Außenelektrode 20 verbunden ist. Ferner weist der Aktor 2 ein als Aktorfuß ausgestaltetes Übergangsstück 25 und ein als Aktorkopf ausgestaltetes Übergangsstück 26 auf. Das Übergangsstück 25 stützt sich an dem Ventilgehäuse 3 ab. Die Außenelektroden 19, 20 sind mit elektrischen Leitungen 27, 28 verbunden, die durch das Übergangsstück 25 geführt sind. Durch Anlegen einer gewissen Spannung zwischen die elektrischen Leitungen 27, 28 wird der Aktorkörper 12 geladen oder entladen, so dass es zu einer Dehnung beziehungsweise Verkürzung des Aktorkörpers 12 kommt. Dabei ist der Aktorkörper 12 vorzugsweise durch eine auf das Übergangsstück 26 einwirkende Vorspannkraft F, die beispielsweise von einer Feder erzeugt werden kann, vorgespannt. Eine Betätigung des Aktors 2 wirkt sich in einer Verschiebung des Übergangsstücks 26 in oder entgegen der Richtung der Vorspannkraft F aus, die sich direkt oder mittelbar, wie es durch den Doppelpfeil 29 dargestellt ist, auf die Ventilnadel 11 überträgt. Somit kann durch die Betätigung des Aktors 2 eine Verstellung der Ventilnadel 11 erreicht werden, wodurch ein Öffnen oder Schließen des zwischen dem Ventilschließkörper 10 und der Ventilsitzfläche 9 ausgebildeten Dichtsitzes erreicht wird. Dadurch ist eine Steuerung der Abspritzmenge des in dem Brennstoffraum 5 vorgesehenen Brennstoffs in eine Brennkammer der Brennkraftmaschine über zumindest eine Düsenöffnung 30 möglich.

Die Übergangsstücke 25, 26 sind elektrisch leitend ausgestaltet und sind direkt oder mittelbar mit dem metallischen Ventilgehäuse 3 elektrisch verbunden. Im montierten Zustand des Brennstoffeinspritzventils 1 liegt das Ventilgehäuse 3 über dem Motorblock auf der elektrischen Masse des Fahrzeugs. Die an die elektrischen Leitungen 27, 28 angelegte elektrische Spannung ist aber nicht notwendigerweise auf diese elektrische Masse bezogen. Beim Laden und Entladen des Aktorkörpers 12, das mit hoher Frequenz erfolgt, kann es zu einem Störstrom über einen parasitären Koppelkondensator kommen, der zwischen der Elektrodenschicht 14 und dem Übergangsstück 26 gebildet ist. Die passive keramische Schicht 16 weist eine hohe Permittivität, insbesondere eine hohe relative Dielektrizitätskonstante, auf, so dass in Bezug auf die passive keramische Schicht 16 eine relativ große Koppelkapazität erzeugt werden würde. Da der im Betrieb erzeugte Störstrom proportional zur Größe der Koppelkapazität ist, wäre ein entsprechend großer Störstrom die Folge. Dies würde sich ungünstig auf die elektromagnetische Verträglichkeit auswirken.

Um die Koppelkapazität zu reduzieren, ist zwischen der passiven keramischen Schicht 16 an dem Ende 15 des Aktorkörpers 12 und dem Übergangsstück 26 eine Glaskeramikplatte 35 vorgesehen. Die Glaskeramikplatte 35 ist klebstofffrei mit dem Übergangsstück 26 verbunden. Ferner ist die Glaskeramikplatte 35 durch Sintern mit dem Aktorkörper 12 verbunden. Hierbei wird während des Sintervorgangs eine Sinterverbindung zwischen der Glaskeramikplatte 35 und der passiven keramischen Schicht 16 ausgebildet. Entsprechend ist auch zwischen der weiteren passiven keramischen Schicht 18, die an dem weiteren Ende 17 des Aktorkörpers 12 ausgebildet ist, und dem Übergangsstück 25 eine Glaskeramikplatte 36 vorgesehen, die entsprechend der Glaskeramikplatte 35 ausgestaltet ist und eine entsprechende Funktion hat.

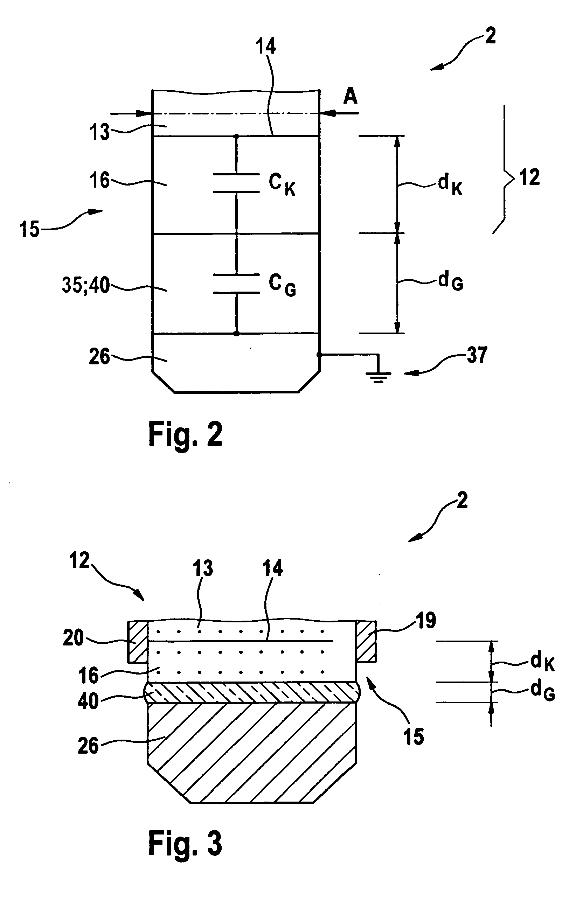

Die Ausgestaltung und Funktion der Glaskeramikplatte 35 ist im Folgenden anhand der Fig. 2 in weiterem Detail erläutert.

Fig. 2 zeigt den in Fig. 1 mit II bezeichneten Ausschnitt eines piezoelektrischen Aktors 2 eines Brennstoffeinspritzventils 1 mit einem Ersatzschaltbild. Das Übergangsstück 26 ist mit elektrischer Masse 37 verbunden. Im Betrieb des Brennstoffeinspritzventils wird an die Elektrodenschicht 14 eine Spannung mit hoher Frequenz angelegt. Die Elektrodenschicht 14, das metallische Übergangsstück 26 sowie die dazwischen liegenden Medien der passiven keramischen Schicht 16 und der Glaskeramikplatte 35 bilden näherungsweise einen Plattenkondensator mit der Querschnittsfläche A.

Die Kapazität C eines Plattenkondensators lässt sich allgemein beschreiben durch

$$(1) \quad C = \varepsilon_0 \, \varepsilon_r \, A/d.$$

Dabei ist $\varepsilon_0$ die elektrische Feldkonstante, A ist jeweils die Fläche der Kondensatorplatte und d ist der Abstand der Platten zueinander. Die Permittivität, die auch Dielektrizität oder dielektrische Permeabilität genannt wird, ist im Fall eines homogenen Mediums gegeben durch:

$$(2) \quad \varepsilon = \varepsilon_0 \, \varepsilon_r.$$

Die relative Permittivität $\varepsilon_r$ wird hier allgemein zur Beschreibung des Kondensators verwendet, wobei nicht notwendigerweise eine über das Medium eines Kondensators konstante Dielektrizitätskonstante oder relative Permittivität angenommen wird. Allerdings unterscheidet sich die Permittivität $\varepsilon_r$ der passiven keramischen Schicht 16 wesentlich von der Permittivität der Glaskeramikplatte 35, so dass in der Fig. 2 ein Ersatzschaltbild mit einem Kondensator $C_K$ für die passive keramische Schicht 16 und einem Kondensator $C_G$ für die Glaskeramikplatte 35 verwendet wird. Diese beiden Kondensatoren $C_K$ und $C_G$ sind in Reihe geschaltet. Die Gesamtkapazität $C_S$ ergibt sich gemäß:

$$(3) \quad 1/C_S = 1/C_K + 1/C_G.$$

Somit ist offensichtlich die Gesamtkapazität $C_S$ kleiner als jede der Einzelkapazitäten $C_K$ und $C_G$, so dass insbesondere gilt:

$$(4) \quad C_S < C_G.$$

Durch eine entsprechend kleine Kapazität $C_G$ der Glaskeramikplatte 35 kann somit die gesamte parasitäre Koppelkapazität $C_S$ erheblich verringert werden. Beispielsweise kann ausgehend von einer Kapazität $C_K$ der passiven keramischen Schicht 16 von 570 pF eine Gesamtkapazität $C_S$ von gleich oder weniger als 50 pF erreicht werden.

Die passive keramische Schicht 16 weist eine Dicke $d_K$ und zumindest näherungsweise eine Querschnittsfläche A auf. Zusammen mit der relativen Permittivität $\varepsilon_r$ (passive keramische Schicht) der passiven keramischen Schicht 18 ist somit die Kapazität $C_K$ bestimmt. Entsprechend ist die Kapazität $C_G$ der Glaskeramikplatte 35 bei gegebener Querschnittsfläche A über die Dicke $d_G$ der Glaskeramikplatte 35 und die relative Permittivität $\varepsilon_r$ bestimmt. Um die Einbaulänge des piezoelektrischen Aktors 2 zumindest nicht wesentlich zu vergrößern, wird die Dicke $d_G$ der Glaskeramikplatte 35 vorzugsweise relativ klein gewählt, wobei auf Grund der sehr niedrigen relativen Permittivität $\varepsilon_r$ dennoch eine sehr kleine Kapazität $C_G$ der Glaskeramikplatte 35 erreicht werden kann. Beispielsweise kann die Dicke $d_G$ der Glaskeramikplatte 0,2 mm betragen. Sofern auch an dem weiteren Ende 17 eine entsprechende Glaskeramikplatte 36 vorgesehen ist, die ebenfalls eine Dicke von 0,2 mm aufweist, ergibt sich für die Glaskeramikplatten 35, 36 ein sich auf die Einbaulänge auswirkender Platzbedarf von 0,4 mm. Dieser zusätzliche Platzbedarf kann allerdings über eine entsprechende Anpassung des Übergangsstücks 26 korrigiert werden, so dass die gesamte Einbaulänge des piezoelektrischen Aktors 2 unverändert ist. Dadurch kann der modifizierte piezoelektrische Aktor 2 in Brennstoffeinspritzventile 1 eingebaut werden, ohne dass konstruktive Änderungen des jeweiligen Brennstoffeinspritzventils 1 erforderlich sind.

Die Glaskeramikplatte 35 hat erfindungsgemäß eine relative Permittivität, die kleiner als 10 ist. Ferner hat die Glaskeramik der Glaskeramikplatte 35 den Vorteil, dass eine definierte Dicke $d_G$ vorgegeben werden kann. Insbesondere kann mit relativ geringem Aufwand eine Einhaltung der geforderten Toleranzen, insbesondere der geometrischen Toleranzen und der Oberflächenqualität, eine hohe mechanische Festigkeit, insbesondere ein hoher E-Modul, eine Temperaturbeständigkeit im Bereich von -40°C bis 180°C, insbesondere auch eine gute Temperaturwechselbeständigkeit, und eine kostengünstige Herstellung erreicht werden. Glaskeramik zeichnet sich außerdem durch eine gute mechanische und für die Serienfertigung geeignete Bearbeitbarkeit aus. Speziell kann die Glaskeramikplatte eine relative Permittivität von kleiner als 6 aufweisen. Insbesondere kann die mechanische Bearbeitung der Glaskeramikplatte 35, gegebenenfalls zusammen mit dem übrigen Aktorkörper 12, durch Drehen, Fräsen, Bohren, Gewindeschneiden oder dergleichen erfolgen. Ferner ist ein relativ hoher E-Modul vorgebbar, der beispielsweise aus dem Bereich von 20 kN/mm² bis 50 kN/mm² gewählt werden kann.

Da die Kapazität $C_G$ der Glaskeramikplatte 35 erheblich niedriger als die Kapazität $C_K$ der passiven keramischen Schicht 16 ist, ist gemäß der Formel (4) auch die Gesamtkapazität $C_S$ des parasitären Koppelkondensators erheblich niedriger als die Kapazität $C_G$ der Glaskeramikplatte 35. Entsprechendes gilt auch für die parasitäre Kapazität an dem weiteren Ende 17. Störströme durch das Fahrzeug können somit erheblich abgeschwächt werden, so dass die elektromagnetische Verträglichkeit verbessert ist. Ferner kann insbesondere die Störung eines Radioempfangs vermieden werden.

Fig. 3 zeigt den in Fig. 1 mit II bezeichneten Ausschnitt eines piezoelektrischen Aktors 2 eines Brennstoffeinspritzventils 1 gemäß einem zweiten nicht erfindungsgemäßen Ausführungsbeispiel. In diesem nicht erfindungsgemäßen Ausführungsbeispiel ist an Stelle der Glaskeramikplatte 35 eine Glasschicht 40 vorgesehen. Die Glasschicht 40 ist auf das Übergangsstück 26 aufgeschmolzen, so dass eine mechanisch belastbare Verbindung zwischen dem Übergangsstück 26 und der Glasschicht 40 gebildet ist. Insbesondere ist keine Klebstoffschicht erforderlich, um die Glasschicht 40 in ihrer Lage zu fixieren. Die Glasschicht 40 weist eine Dicke $d_G$ und zumindest näherungsweise eine Querschnittsfläche A (Fig. 2) auf. Eine relative Permittivität der Glasschicht 40 ist vorzugsweise kleiner als 10, insbesondere kleiner als 6, gewählt. Die Reduzierung der gesamten parasitären Kapazität $C_S$ ergibt sich somit aus der Kapazität $C_K$ der passiven keramischen Schicht 18 und der Kapazität CG der Glasschicht 40. Diesbezüglich kann auf die anhand der Fig. 2 gemachten Ausführungen verwiesen werden, wobei anstelle der Glaskeramikplatte 35 die Glasschicht 40 betrachtet wird.

## Patentansprüche

1. Piezoelektrischer Aktor (2), insbesondere Aktor für Brennstoffeinspritzventile, mit einem Aktorkörper (12), der eine Vielzahl von keramischen Schichten (13) und eine Vielzahl von zwischen den keramischen Schichten (13) angeordneten Elektrodenschichten (14) aufweist, und zumindest einem elektrisch leitenden Übergangsstück (26), wobei zwischen einer an einem Ende (15) des Aktorkörpers (12) vorgesehenen passiven keramischen Schicht (16) des Aktorkörpers (12) und dem Übergangsstück (26) eine Glaskeramikplatte (35) vorgesehen ist, **dadurch gekennzeichnet, dass** die Glaskeramikplatte (35) eine Dicke aufweist, die aus einem Bereich von etwa 150 μm bis etwa 250 μm ist und dass die Glaskeramikplatte (35) so ausgestaltet ist, dass eine relative Permittivität der Glaskeramikplatte (35) kleiner als 10, insbesondere kleiner als 6, ist.

2. Piezoelektrischer Aktor nach Anspruch 1, **dadurch gekennzeichnet, dass** die Glaskeramikplatte (35) eine Dicke von etwa 200 μm aufweist.

3. Piezoelektrischer Aktor nach Anspruch 1 oder 2, **dadurch gekennzeichnet, dass** die Glaskeramikplatte (35) klebstofffrei mit dem Aktorkörper (12) verbunden ist.

4. Piezoelektrischer Aktor nach Anspruch 1, 2 oder 3, **dadurch gekennzeichnet, dass** die Glaskeramikplatte (35) durch Sintern mit den keramischen Schichten (13) verbunden ist.

5. Piezoelektrischer Aktor nach einem der Ansprüche 1 bis 4, **dadurch gekennzeichnet, dass** ein weiteres Übergangsstück (25) vorgesehen ist und dass zwischen einer an einem weiteren Ende (17) des Aktorkörpers (12) vorgesehenen weiteren passiven keramischen Schicht (18) des Aktorkörpers (12) und dem weiteren Übergangsstück (25) eine weitere Glaskeramikplatte (35) und/oder eine Glasschicht (40) vorgesehen ist.

6. Brennstoffeinspritzventil (1), insbesondere Injektor für Brennstoffeinspritzanlagen von luftverdichtenden, selbstzündenden Brennkraftmaschinen, mit einem piezoelektrischen Aktor (2) nach einem der Ansprüche 1 bis 5 und einem von dem Aktor (2) betätigbaren Ventilschließkörper (10), der mit einer Ventilsitzfläche (9) zu einem Dichtsitz zusammenwirkt.

## Claims

1. Piezoelectric actuator (2), in particular actuator for fuel injection valves, having an actuator body (12), which has a multiplicity of ceramic layers (13) and a multiplicity of electrode layers (14) arranged between the ceramic layers (13), and at least one electrically conductive transition piece (26), wherein a glass ceramic plate (35) is provided between a passive ceramic layer (16) of the actuator body (12), provided at one end (15) of the actuator body (12), and the transition piece (26), **characterized in that** the glass ceramic plate (35) has a thickness from a range of approximately 150 $\mu$m to approximately 250 $\mu$m, and **in that** the glass ceramic plate (35) is configured in such a way that a relative permittivity of the glass ceramic plate (35) is less than 10, in particular less than 6.

2. Piezoelectric actuator according to Claim 1, **characterized in that** the glass ceramic plate (35) has a thickness of approximately 200 $\mu$m.

3. Piezoelectric actuator according to Claim 1 or 2, **characterized in that** the glass ceramic plate (35) is connected to the actuator body (12) without adhesive.

4. Piezoelectric actuator according to Claim 1, 2 or 3, **characterized in that** the glass ceramic plate (35) is connected to the ceramic layers (13) by sintering.

5. Piezoelectric actuator according to one of Claims 1 to 4, **characterized in that** a further transition piece (25) is provided, and **in that** a further glass ceramic plate (35) and/or a glass layer (40) is provided between a further passive ceramic layer (18) of the actuator body (12), provided at a further end (17) of the actuator body (12), and the further transition piece (25).

6. Fuel injection valve (1), in particular injector for fuel injection systems of air-compressing, auto-ignition internal combustion engines, having a piezoelectric actuator (2) according to one of Claims 1 to 5 and a valve closing body (10), which can be actuated by the actuator (2) and interacts with a valve seat face (9) to form a sealing seat.

## Revendications

1. Actionneur piézoélectrique (2), en particulier actionneur pour des soupapes d'injection de carburant, comprenant un corps d'actionneur (12), qui présente une pluralité de couches céramiques (13) et une pluralité de couches d'électrodes (14) disposées entre les couches céramiques (13), et comprenant au moins une pièce de transition électriquement conductrice (26), une plaque en vitrocéramique (35) étant prévue entre une couche céramique passive (16) du corps d'actionneur (12) prévue à une extrémité (15) du corps d'actionneur (12) et la pièce de transition (26), **caractérisé en ce que** la plaque en vitrocéramique (35) présente une épaisseur comprise dans une plage d'environ 150 $\mu$m à environ 250 $\mu$m et **en ce que** la plaque en vitrocéramique (35) est configurée de telle sorte qu'une permissivité relative de la plaque en vitrocéramique (35) soit inférieure à 10, en particulier inférieure à 6.

2. Actionneur piézoélectrique selon la revendication 1, **caractérisé en ce que** la plaque en vitrocéramique (35) présente une épaisseur d'environ 200 $\mu$m.

3. Actionneur piézoélectrique selon la revendication 1 ou 2, **caractérisé en ce que** la plaque en vitrocéramique (35) est connectée sans adhésif au corps d'actionneur (12).

4. Actionneur piézoélectrique selon la revendication 1, 2 ou 3, **caractérisé en ce que** la plaque en vitrocéramique (35) est connectée aux couches céramiques (13) par frittage.

5. Actionneur piézoélectrique selon l'une quelconque des revendications 1 à 4, **caractérisé en ce qu'**une pièce de transition supplémentaire (25) est prévue et **en ce qu'**entre une couche céramique passive supplémentaire (18) du corps d'actionneur (12) prévue au niveau d'une extrémité supplémentaire (17) du corps d'actionneur (12) et la pièce de transition supplémentaire (25) est prévue une plaque en vitrocéramique supplémentaire (35) et/ou une couche de verre (40).

6. Soupape d'injection de carburant (1), en particulier injecteur pour des installations d'injection de carburant de moteurs à combustion interne à auto-allumage et compression d'air, comprenant un actionneur piézoélectrique (2) selon l'une quelconque des revendications 1 à 5 et un corps de fermeture de soupape (10) pouvant être commandé par l'actionneur (2), lequel corps de fermeture de soupape coopère avec une surface de siège de soupape (9) pour former un siège d'étanchéité.

**Fig. 1**

**14**

**A**

**13**

**16**

**15**

**$C_K$**

**$d_K$**

**12**

**35; 40**

**$C_G$**

**$d_G$**

**26**

**37**

# Fig. 2

**12**

**13**

**14**

**20**

**19**

**16**

**$d_K$**

**40**

**$d_G$**

**26**

**15**

# Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10025998 A1

- DE 102004002133 A1